Europäisches Patentamt

European Patent Office

Office européen des brevets

(11) Publication number: **0 420 407 A1**

# EUROPEAN PATENT APPLICATION

(21) Application number: 90308942.3

(22) Date of filing: 14.08.90

(51) Int. Cl.5: **H01R 9/09, H01R 23/70**

(30) Priority: 25.08.89 JP 219010/89

(43) Date of publication of application:
03.04.91 Bulletin 91/14

(84) Designated Contracting States:
DE FR GB IT

(71) Applicant: AMP INCORPORATED
470 Friendship Road
Harrisburg Pennsylvania 17105(US)

(72) Inventor: Furuya, Tetsuyuki
39 Nishikubocho, Hodogaya-ku
Yokohama-shi, Kanagawa(JP)
Inventor: Onoue, Nobuaki, Life Core
Higashi-rinkan Annex 604, 7-9-2
Kami-tsuruma
Sagamihira-shi, Kanagawa(JP)
Inventor: Kikuchi, Shoji
43-4 Sengokugashi
Hiratsuka-shi, Kanagawa(JP)

(74) Representative: Warren, Keith Stanley et al
BARON & WARREN 18 South End Kensington
London W8 5BU(GB)

(54) Electrical connector.

(57) An electrical connector (1) for receiving an edge of a circuit board (4) includes several generally C-shaped contacts (3) carried in a housing (2) and each having spaced apart contact sections (6,7) facing each other and interconnected by a resilient section (9).

Figure 3A

Figure 3B

Figure 3C

EP 0 420 407 A1

## ELECTRICAL CONNECTOR

The present invention relates to an electrical connector for electrically receiving a substrate having contact pads on both surfaces of the substrate along its edge.

When installing a substrate 100 such as an HIC circuit board, as shown in Figure 5, it was a common practice to solder joint substantially F-shaped contacts 103 having two contact sections 103a, 103b contacting both upper and bottom surfaces of the substrate 100 with contact pads along the edge of the substrate 100. Before and during installation on the substrate 100, the contacts 103 are supported continuously on a carrier strip 104 and then removed after soldering the contact sections 103a, 103b on substrate 100. The separated tine sections 105 extending downwardly are then inserted into a printed circuit board (not shown).

It is now proposed to provide an electrical connector which electrically receives a substrate without soldering the contacts and further which can be surface mounted on a circuit board.

According to the invention, an electrical connector is provided having a plurality of contacts carried in a housing and with each contact having a pair of facing contact sections interconnected by a resilient section.

An embodiment of the invention will now be described by way of example with reference to the accompanying drawings, in which:-

Figure 1 is a perspective view of one embodiment of the electrical connector according to the present invention;

Figure 2 is a cross sectional view of the embodiment as illustrated in Figure 1;

Figures 3A through 3C are simplified cross sectional views to illustrate steps of installation of a substrate in the above embodiment;

Figure 4 is a side view illustrating solder joints in the above embodiment; and

Figure 5 is one example of a prior art electrical connector.

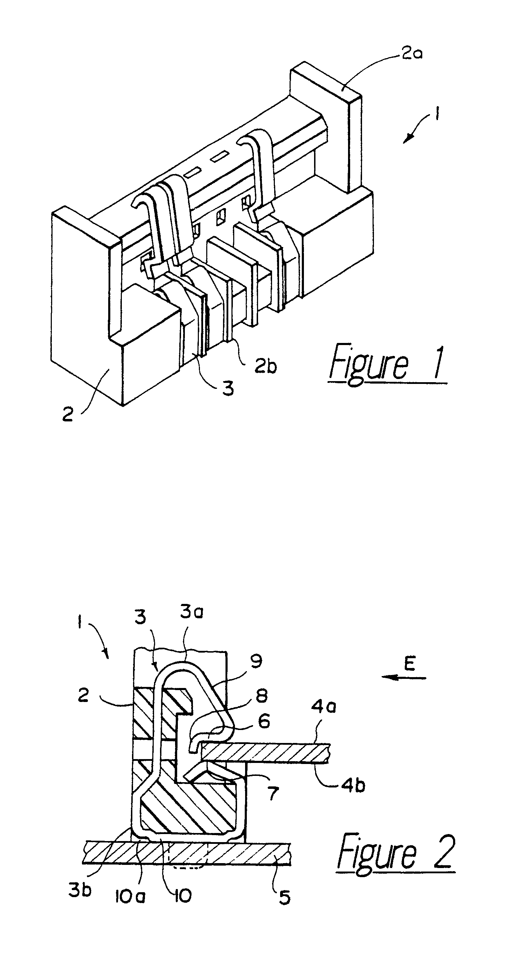

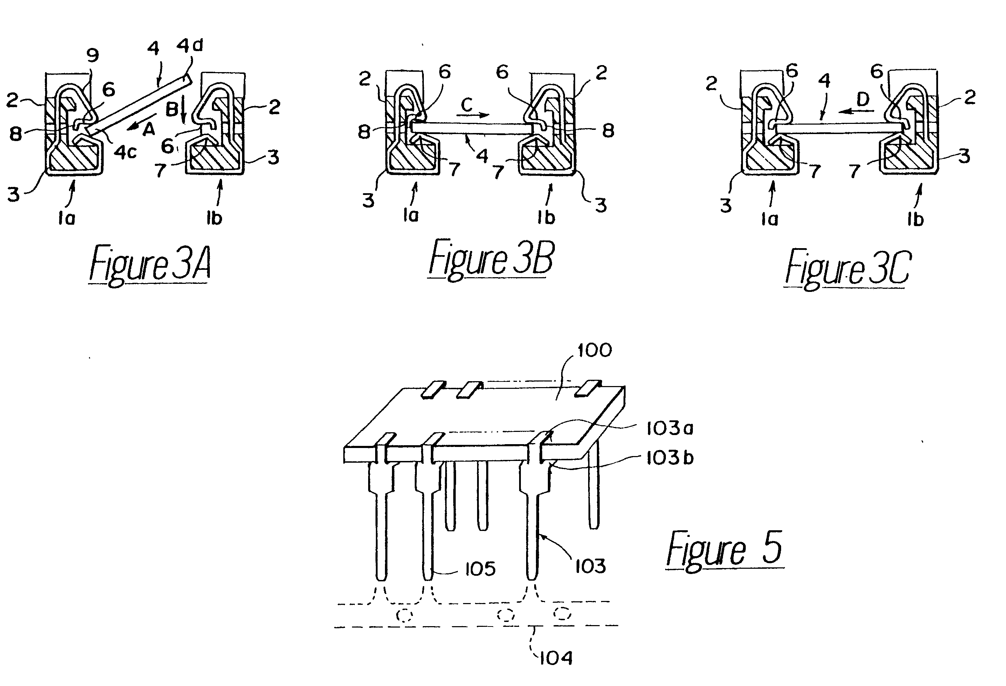

As shown in Figures 1 and 2, electrical connector 1 of the preferred embodiment is one for substrate 4 having contact pads (not shown) on both surfaces along the edge. Connector 1 comprises a plurality of contacts 3 retained at a constant pitch in a housing 2 made from a suitable plastic material. A pair of symmetrical connectors 1 are disposed on a printed circuit board 5 in opposite relationship to each other as shown in Figures 3A-3C. The substrate 4 is clipped between a pair of connectors 1 with contacts 3 contacting both upper and bottom surfaces of the substrate 4.

The contact 3 has at one end thereof, a first contact section 6 in contact with the upper surface 4a of the substrate 4 and at another end thereof a second contact section 7 in contact with the bottom surface 4b. In other words, the contact 3 is an integral generally C-shaped member comprising an upper contact leaf 3a including the first contact section 6 and a lower contact leaf 3b including the second contact section 7. The two contact sections 6 and 7 are integrally coupled to each other by way of a resilient section 9 and a tine section 10. The substrate 4 is supported between the contact sections 6, 7 intercoupled by a common tine section 10.

A stopper section 8 is formed at a free end of the first contact section 6 of the upper contact leaf 3a. Also, a resilient section 9 is formed above the first contact section 6. The resilient section 9 integral with the stopper section 8 is resiliently movable toward inside of the housing. When a force is applied toward inside of the housing (as represented by an arrow E), the resilient section 9 is resiliently deformed. Accordingly, both of the first contact section 6 and the stopper section 8 resiliently move toward inside of the housing, thereby providing a space to insert the substrate 4 between the contact sections 6 and 7.

The lower contact leaf 3b has the tine section 10 to interconnect the two contact sections 6 and 7. The tine section 10 is formed by externally exposing the contact leaf 3b from the bottom of the housing 2. The connector 1 is mounted on the printed circuit board 5 by soldering at the tine section 10.

A pair of connectors 1a, 1b each having a plurality of such contacts 3 are mounted on the circuit board 5 in opposite relation to each other. Illustrated in Figures 3A through 3C are the steps of installation of the substrate 4 between such connectors 1a, 1b.

One edge 4c of the substrate 4 is inserted between the contact sections 6, 7 of one connector 1a and a force is simultaneously applied in the direction of insertion of the substrate 4 to push the stopper section 8 by one edge 4c as illustrated by arrow A. Accordingly, the resilient section 9 is resiliently deformed, thereby resiliently moving the first contact section 6 from its contacting position to the substrate installation position. One edge 4c is, then, inserted between the contact sections 6, 7 and the other edge 4d is permitted to move downwardly near the contact sections 6, 7 of the other connector 1b (in the direction as represented by an arrow B), thereby placing the substrate 4 between the connectors 1a, 1b as illustrated in Figure 3B. Since the substrate 4 had been pushed toward connector 1a, the substrate 4 is biased to the connector 1a, thereby remaining at a non-contacting position with the contact sections 6, 7 of the other connector 1b. However, the recovering force of the resilient section 9 pushes back in the direction as represented by an arrow C and the substrate 4, having one edge 4c abutting against the stopper 8, moves to the proper position for making contact with the contact sections 6, 7 of the both connectors 1a, 1b as illustrated in Figure 3c. Under this condition, the edge 4d of the other connector 1b abuts against the stopper 8 which applies a pressure to resiliently push the substrate 4 in the direction as represented by an arrow D. The substrate 4 is, then, latched at a proper position.

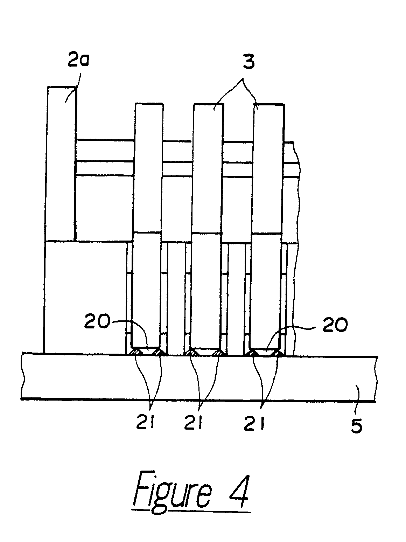

It is to be understood that, in the embodiment as illustrated in Figure 4, beads 20 are formed on the bottom surfaces of the tine sections 10 along the longitudinal direction thereof and extending toward the printed circuit board 5 to insure soldering of the tine sections 10 on the printed circuit board 5. The bottom surfaces of the beads 20 abuts against the printed circuit board 5 when mounted thereon, thereby avoiding the side edges of the beads of the tine sections 10 to abut against the printed circuit board 5. Gaps created by such particular construction allows solder 21 to flow along the side edges in order to improve strength of the soldering between the printed circuit board 5 and the tine section 10.

As mentioned above, the substrate 4 and the contacts 3 are not soldered in the present embodiment, rather the substrate 4 is installed onto a proper position where the contact sections 6, 7 of the contact 3 are in contact with the upper and bottom surfaces of the substrate 4. This allows the substrate 4 to be easily removed from the connector after installation for convenience of troubleshooting of the substrate or other purposes.

Also, positioning of the contacts 3 in isolation walls 2b within the housing 2 maintains the pitch of the contacts 3 during mounting, thereby enabling the substrate 4 to be installed between the contacts 3 supported at predetermined pitch. Additionally, positioning the substrate 4 between end walls 2a of the housing 2 effectively aligns the conductive patterns on the substrate 4 with the contacts 3.

The resiliency of contact leaf 3a to push the substrate externally (i.e., in the opposite direction to the arrow E) latches the substrate 4 between the pair of stoppers 8 to define the contact position between the contact 3 and the substrate 4. this provides a stable support for the substrate 4 within connectors 1a, 1b.

Resiliently movable construction of the contact sections 6 by virtue of the resilient sections 9 absorbs certain differences in the distance between the two connectors 1a, 1b and in the thickness of the substrate (0.40 through 0.65 mm), thereby providing further stable support of the substrate 4.

Also, since the tine sections are formed on the bottom surfaces of the housings between two contact sections, the connector occupies minimum area.

As can be discerned, an electrical connector has been disclosed for electrically engaging opposite edges of a substrate. The connector includes C-shaped contacts retained in a housing at a constant pitch. The contacts include resilient sections for engaging the substrate with one section having a stopper section which abuts the edge of the substrate whereby the section is resiliently moved in as the substrate is inserted and then returns to properly center the substrate.

## Claims

1. An electrical connector (1) for receiving an edge of a circuit board (4) between a pair of contact sections (6,7) on a plurality of contacts (3) carried in a housing (2), characterised in that each of said contacts (3) includes a resilient section (9) to couple said contact sections (6,7) to a common tine section (10).

2. The electrical connector (1) of claim 1 further characterised in that a stopper section (8) is provided at a free end of one of the contact sections (6).

3. The electrical connector (1) of claim 2 further characterised in that the contacts (3) are C-shaped and include an upper lead (3a) with one contact section (6) at an end thereof and a lower lead (3b) with another contact section (7) at an end thereof.

4. The electrical connector (1) of claim 3 further characterised in that the resilient section (9) is resiliently movable in the housing.

5. The electrical connector (1) of claim 4 further characterised in that the contact sections (6,7) face each other.

*Figure 1*

*Figure 2*

Figure 3A

Figure 3B

Figure 3C

Figure 5

EP 0 420 407 A1

_Figure 4_

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-3 689 684 (J.J. COX et al.) * figures 1-3; column 2, line 53 - column 3, line 10; column 3, lines 51-64 * | 1-5 | H 01 R 9/09 H 01 R 23/70 |
| A | IBM TECHNICAL DISCLOSURE BULLETIN vol. 28, no. 10, March 1986, pages 4360,4361, New York, US; "Surface Mount Substrate Lead" * the whole document * | 1-5 | |
| A | DE-A-2 930 506 (LICENTIA) * figures 1,3; page 5, line 18 - page 6, line 31 * | 1-5 | |
| A | DE-U-8 622 143 (DU PONT DE NEMOURS B.V.) * figures 1-4; page 6, line 21 - page 8, line 11 * | 1-5 | |
| A | DE-A-2 413 989 (ELECTROVAC) * figures 1,2; page 5, line 14 - page 6, line 22 * | 1,2 | **TECHNICAL FIELDS SEARCHED (Int. Cl.5)** H 01 R 9/00 H 01 R 23/00 |

The present search report has been drawn up for all claims

| Place of search | Date of completion of the search | Examiner |
|---|---|---|
| BERLIN | 29-11-1990 | HAHN G |